(19) Europäisches Patentamt
European Patent Office
Office européen des brevets

(11) **EP 4 597 837 A1**

(12) **EUROPEAN PATENT APPLICATION**
published in accordance with Art. 153(4) EPC

(43) Date of publication:
**06.08.2025 Bulletin 2025/32**

(21) Application number: **23870458.9**

(22) Date of filing: **18.09.2023**

(51) International Patent Classification (IPC):
**H03F 3/20** (2006.01)   **H03F 1/42** (2006.01)
**H03F 3/24** (2006.01)

(52) Cooperative Patent Classification (CPC):
**H04B 1/0458; H03F 1/56; H03F 3/195;**
H03F 2200/222; H03F 2200/318; H03F 2200/387;
Y02D 30/70

(86) International application number:
**PCT/CN2023/119549**

(87) International publication number:
**WO 2024/067226 (04.04.2024 Gazette 2024/14)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: 30.09.2022  CN 202211216074
15.02.2023  CN 202310119049

(71) Applicant: **Vanchip (Tianjin) Technology Co. Ltd
Tianjin 300457 (CN)**

(72) Inventors:
• **CHEN, Gang
Tianjin 300457 (CN)**
• **BAI, Yunfang
Tianjin 300457 (CN)**

(74) Representative: **Wang, Bo
Panovision IP
Ebersberger Straße 3
85570 Markt Schwaben (DE)**

(54) **BALANCED RADIO FREQUENCY POWER AMPLIFIER, RADIO FREQUENCY FRONT-END MODULE, AND ELECTRONIC DEVICE**

(57)    A balanced radio frequency power amplifier, a front-end module, and a corresponding electronic device. The balanced radio frequency power amplifier comprises a driving-stage power unit (101, 201), an inter-stage power divider (102, 202), a main path power amplifier (103, 203), an auxiliary path power amplifier (104, 204), a first output matching network (A105, A205), a second output matching network (B106, B206), and an output power combiner (107, 207). A symmetrical balance design is used for the main path power amplifier (103, 203) and the auxiliary path power amplifier (104, 204), so that the impact of the change in the antenna voltage standing wave ratio (VSWR) on the transmission power and the transmitting efficiency is overcome to the greatest extent. Moreover, a 3 dB distributed orthogonal coupler is used for the inter-stage power divider (102, 202) and the output power combiner (107, 207), so that performance indicators of the radio frequency power amplifier such as the area size, the bandwidth, the insertion loss, and the transmitting efficiency are optimally balanced and optimized.

FIG. 1

## Description

## BACKGROUND

## Technical Field

The present disclosure relates to a balanced radio frequency power amplifier, a radio frequency front-end module including the balanced radio frequency power amplifier, and a corresponding electronic device, which belong to the technical field of radio frequency integrated circuits.

## Related Art

With continuous development of communication technologies, a mobile communication terminal has a higher requirement on the performance of a radio frequency front-end module. As an important part of the radio frequency front-end module, main technical performance indicators of a radio frequency (RF) power amplifier such as bandwidth, gain, loss, linearity, transmission power and efficiency, service life, and area size are of particular importance. In the radio frequency front-end module of the mobile communication terminal, the radio frequency power amplifier is a device having the highest power consumption, and reducing the power consumption of the radio frequency power amplifier is also the most effective method for improving the service life of the device. Among many factors that affect the performance of the radio frequency power amplifier, an architecture of the radio frequency power amplifier and an antenna standing wave ratio are two crucial factors that improve the efficiency of the radio frequency power amplifier. The antenna standing wave ratio changes with a change of a usage scenario. The change of the antenna standing wave ratio directly affects a load line of the radio frequency power amplifier, and further affects the transmission power and transmitting efficiency of the radio frequency power amplifier.

In a mobile communication terminal in a 5G communication system, since frequencies of band n41, band n77, and band n79 are relatively high and spatial path attenuation is relatively large, a mobile standard requires the three bands to all achieve a PC2-level transmission power. To be specific, the transmission power of an antenna is 26 dBm. The high transmission power causes a higher direct current power consumption of the radio frequency power amplifier, and under the same transmitting efficiency, the radio frequency power amplifier generates much heat, so that battery consumption is higher and a standby time is shortened. Therefore, in a case of the PC2-level transmission power, the foregoing problems are solved by further optimizing linearity of the radio frequency power amplifier and improving efficiency of the radio frequency power amplifier. Also, bandwidths of band n41, band n77, and band n79 are respectively 200 MHz, 900 MHz, and 600 MHz, and a maximum bandwidth of a radio frequency signal is 200 MHz. Therefore, it is further needed to improve the bandwidth of the radio frequency power amplifier, and improve the linearity of the radio frequency power amplifier under a broadband signal.

## SUMMARY

A first technical problem to be solved by the present disclosure is to provide a balanced radio frequency power amplifier.

Another technical problem to be solved by the present disclosure is to provide a radio frequency front-end module including the balanced radio frequency power amplifier and a corresponding electronic device.

To achieve the foregoing object, the present disclosure adopts the following technical solution.

According to a first aspect of an embodiment of the present disclosure, a balanced radio frequency power amplifier is provided, including a driving-stage power unit, an inter-stage power divider, a main path power amplifier, an auxiliary path power amplifier, a first output matching network A, a second output matching network B, and an output power combiner.

An input end of the driving-stage power unit receives an input radio frequency signal, and an output end is connected to an input end of the inter-stage power divider and is configured to drive and amplify the input radio frequency signal.

An in-phase output end of the inter-stage power divider is connected to an input end of the main path power amplifier, and a quadrature-phase output end of the inter-stage power divider is connected to an input end of the auxiliary path power amplifier and is configured to generate two radio frequency signals having equal amplitudes and a phase difference of 90°.

An output end of the main path power amplifier is connected to an input end of the first output matching network A, and an output end of the auxiliary path power amplifier is connected to an input end of the second output matching network B. An output end of the first output matching network A is connected to an in-phase input end of the output power combiner, and an output end of the second output matching network B is connected to a quadrature-phase input end of the output power combiner.

The output power combiner is configured to receive two radio frequency signals having a same amplitude and a phase difference of 90°, and combine the two radio frequency signals into an output radio frequency signal.

Preferably, the inter-stage power divider includes a 3 dB distributed orthogonal coupler formed by on-chip metal coupling lines. A chip metal laminated coupling structure or a same-layer coupling structure is used.

Preferably, the output power combiner includes a 3 dB distributed orthogonal coupler formed by on-substrate metal coupling lines. A substrate metal laminated coupling structure or a same-layer coupling structure is used.

Preferably, the main path power amplifier includes a first capacitor C9, a first inductor L9, a first transistor M1, a linear circuit, and a bias circuit. The input end of the main path power amplifier is connected to the first capacitor C9, the first inductor L9, and the linear circuit. The other end of the first inductor L9 is connected to a ground potential end. The other end of the first capacitor C9 is connected to a gate of the first transistor M1 and the bias circuit. A source of the first transistor M1 is connected to the ground potential end. A drain of the first transistor M1 is connected to the output end of the main path power amplifier. The first capacitor C9 and the first inductor L9 form an input matching network.

Preferably, the linear circuit is formed by connecting a resistor in series with an array of diodes connected in parallel forwardly and reversely. The resistor is connected to an input end of a power amplifier circuit, and the diodes are connected to the ground potential end.

The linear circuit reduces a pre-distortion amplitude by increasing the number of diodes connected in series, and enhances the pre-distortion amplitude by increasing the number of diodes connected in parallel or the area of the diodes.

Preferably, the bias circuit includes a seventh resistor R7, an eighth resistor R8, a third capacitor C5, a third transistor T1, and a fourth transistor T2. A drain of the third transistor T1 and the seventh resistor R7 are connected and then jointly to a bias voltage end. A gate of the third transistor T1 is connected to the other end of the seventh resistor R7, the third capacitor C5, and a drain of the fourth transistor T2. The other end of the third capacitor C5 is connected to the ground potential end. A source of the fourth transistor T2 is connected to the ground potential end. A gate of the fourth transistor T2 is connected to a source of the third transistor T1 and a bias current output end via the eighth resistor R8.

The third transistor T1 is an emitter follower transistor, and the fourth transistor T2 is a feedback amplification transistor.

Preferably, the first output matching network A and the second output matching network B are both high-bandwidth matching networks formed by lumped devices.

The first output matching network A includes a fourth capacitor C1, a fifth capacitor C2, a sixth capacitor C3, a seventh capacitor C4, a third inductor L1, a fourth inductor L2, a fifth inductor L3, and a sixth inductor L4. The input end of the first output matching network A is separately connected to the fifth capacitor C2, the sixth capacitor C3, and the third capacitor L1. The other end of the fifth capacitor C2 is connected to the fourth inductor L2, and the other end of the fourth inductor L2 is connected to the ground potential end. The other end of the third inductor L1 is connected to a power voltage end and the fourth capacitor C1, and the other end of the fourth capacitor C1 is connected to the ground potential end. The other end of the sixth capacitor C3 is connected to the fifth inductor L3 and the sixth inductor L4. The other end of the fifth inductor L3 is connected to the ground potential end. The other end of the sixth inductor L4 is connected to the seventh capacitor C4 and the output end of the first output matching network A. The other end of the seventh capacitor C4 is connected to the ground potential end.

The fourth capacitor C1 is a power filter capacitor, and the first output matching network A and the second output matching network B jointly use one power filter capacitor.

The fifth capacitor C2 and the fourth inductor L2 are connected in series to form a resonance network for adjusting a harmonic impedance, and a variable capacitor is used as the fifth capacitor C2.

The sixth capacitor C3, the seventh capacitor C4, the fifth inductor L3, and the sixth inductor L4 form a CLLC-type impedance matching network.

Preferably, when an antenna phase changes, a load line impedance of a main path power amplification unit and a load line impedance of an auxiliary path power amplification unit of the balanced radio frequency power amplifier change alternately, and output powers and output currents of the two power amplification units further change alternately, so that change amounts compensate for each other.

According to a second aspect of the embodiment of the present disclosure, a radio frequency front-end module is provided. The radio frequency front-end module is implemented based on the foregoing balanced radio frequency power amplifier, and includes a substrate, at least one radio frequency power amplifier chip, at least one power supply and control chip, an output matching network, and an output power combiner.

The driving-stage power unit, the inter-stage power divider, the main path power amplifier, and the auxiliary path power amplifier in the balanced radio frequency power amplifier are all integrated on the radio frequency power amplifier chip.

The radio frequency power amplifier chip and the substrate are packaged forwardly or reversely.

The output ends of the main path power amplifier and the auxiliary path power amplifier are separately bonded to the first output matching network A and the second output matching network B via a metal wire, and are directly connected to the first output matching network A and the second output matching network B via a copper pillar or a soldering ball.

According to a third aspect of the embodiment of the present disclosure, an electronic device is provided, including the foregoing balanced radio frequency power amplifier.

Compared with the existing technology, the balanced radio frequency power amplifier provided by the present disclosure has the advantages that a symmetrical balance design is used for the main path power amplifier and the auxiliary path power amplifier, so that the impact of the change in the antenna voltage standing wave ratio on the transmission power and the transmitting efficiency is overcome to the greatest extent. Moreover, a 3 dB distributed orthogonal coupler is used for the inter-stage power divider and the output power combiner which are separately implemented on a chip and a substrate, so that performance indicators of the radio frequency power amplifier such as the area size, the bandwidth, the insertion loss, and the transmitting efficiency are optimally balanced and optimized. At the same time, by adopting the technical solution of a linear circuit, the gain distortion and phase distortion of a power amplifier are improved, and better linearity is obtained. By adopting the technical solution of a bias circuit with low impedance output, the linearity of a broadband signal of a power amplifier circuit is improved, and the processing ability of the broadband signal is improved. Therefore, the balanced radio frequency power amplifier provided by the present disclosure has beneficial effects such as ingenious and proper circuit design, high flexibility, and excellent circuit performance, and is more in line with the requirements of technical performance indicators of a 5G communication system.

## BRIEF DESCRIPTION OF THE DRAWINGS

FIG. 1 is a structural block diagram of a balanced radio frequency power amplifier according to an embodiment of the present disclosure.

FIG. 2 is a schematic circuit diagram of a balanced radio frequency power amplifier according to an embodiment of the present disclosure.

FIG. 3(a) is a schematic circuit diagram of a first solution of a linear circuit according to an embodiment of the present disclosure.

FIG. 3(b) is a schematic circuit diagram of a second solution of a linear circuit according to an embodiment of the present disclosure.

FIG. 3(c) is a schematic circuit diagram of a third solution of a linear circuit according to an embodiment of the present disclosure.

FIG. 4 is a diagram of a pre-distortion behavior of a linear circuit according to an embodiment of the present disclosure.

FIG. 5(a) is a schematic circuit diagram of a bias circuit according to an embodiment of the present disclosure.

FIG. 5(b) is a schematic circuit diagram of a typical bias circuit in the existing technology.

FIG. 6 is a comparison diagram of a simulation test of an output impedance of a bias circuit according to a technical solution of the present disclosure and an existing technical solution.

FIG. 7 is a schematic structural diagram of a 3 dB distributed orthogonal coupler designed by using a laminated circuit according to an embodiment of the present disclosure.

FIG. 8 is a schematic structural diagram of a 3 dB distributed orthogonal coupler designed by using a same-layer circuit according to an embodiment of the present disclosure.

FIG. 9 is a diagram of a simulation test of performance indicators such as an insertion loss, an isolation degree, and a reflection coefficient of an output power combiner within an n77 working band according to an embodiment of the present disclosure.

FIG. 10 is a diagram of a simulation test showing that a load line impedance of a main path power amplification unit and an auxiliary path power amplification unit changes with an antenna phase according to an embodiment of the present disclosure.

FIG. 11 is a diagram of a simulation test showing that an output power of a balanced radio frequency power amplifier changes with an antenna phase according to an embodiment of the present disclosure.

FIG. 12 is a diagram of a simulation test showing that a working current of a balanced radio frequency power amplifier changes with an antenna phase according to an embodiment of the present disclosure.

FIG. 13 is a diagram of a simulation test of performance indicators such as a gain, efficiency, and linearity of a balanced radio frequency power amplifier in an n77 band according to an embodiment of the present disclosure.

FIG. 14 is a schematic layout diagram of a balanced radio frequency power amplifier according to an embodiment of the present disclosure.

FIG. 15 is an exemplary diagram of an electronic device employing a balanced radio frequency power amplifier provided by an embodiment of the present disclosure.

## DETAILED DESCRIPTION

Hereinafter, the technical solutions of the present disclosure will be further described in detail with reference to the drawings and specific embodiments.

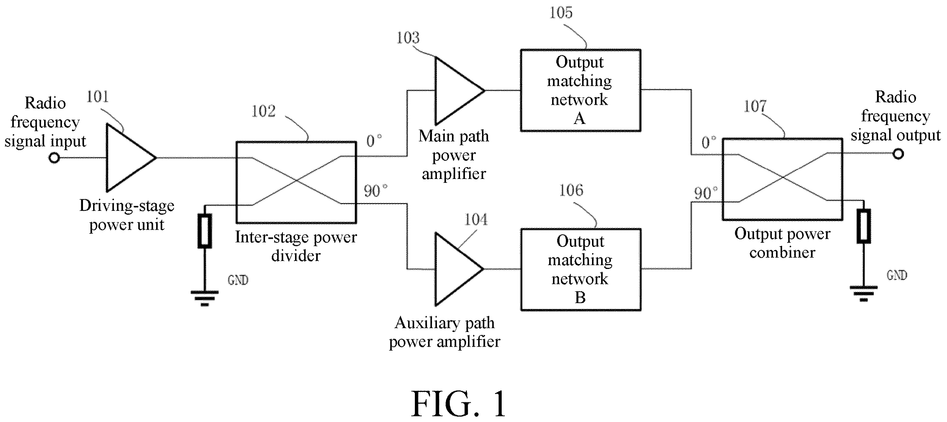

As shown in FIG. 1, a balanced radio frequency power amplifier according to an embodiment of the present disclosure includes a driving-stage power unit 101, an inter-stage power divider 102, a main path power amplifier 103, an auxiliary path power amplifier 104, a first output matching network A105, a second output matching network B106, an output power combiner 107, a radio frequency signal input end, and a radio frequency signal output end. The radio frequency signal input end is connected to an input end of the driving-stage power unit 101. An output end of the driving-stage power unit 101 is connected to an input end of the inter-stage power divider 102. An in-phase output end of the inter-stage power divider 102 is connected to an input end of the main path power amplifier 103. An output end of the main path power amplifier 103 is connected to an input end of the first output matching network A105. An output end of the first output matching network A105 is connected to an in-phase input end of the output power combiner 107. A quadrature-phase output end of the inter-stage power divider 102 is connected to an input end of the auxiliary path power amplifier 104. An output end of the auxiliary path power amplifier 104 is connected to an input end of the second output matching network B106. An output end of the second output matching network B106 is connected to a quadrature-phase input end of the output power combiner 107. An output end of the output power combiner 107 is connected to the radio frequency signal output end.

The driving-stage power unit 101 is configured to drive and amplify an input radio frequency signal and then output the input radio frequency signal to the inter-stage power divider 102. The driving-stage power unit may be a single-stage power unit or a two-stage power unit.

The inter-stage power divider 102 is configured to receive an input radio frequency signal, generate two radio frequency signals having equal amplitudes and a phase difference of 90°, and separately output the two radio frequency signals to the main path power amplifier 103 and the auxiliary path power amplifier 104. This is implemented by a 3 dB distributed orthogonal coupler formed by on-chip metal coupling lines.

The main path power amplifier 103 and the auxiliary path power amplifier 104 are mainly configured to amplify respective input radio frequency signals. The main path power amplifier and the auxiliary path power amplifier are both single-stage amplifiers with a linear circuit and a bias circuit, circuit structures are mutually symmetrical, and circuit element parameters are equal or approximate.

The first output matching network A105 and the second output matching network B106 are configured to separately match an output impedance of the main path power amplifier 103 and an output impedance of the auxiliary path power amplifier 104 to a feature impedance of the output power combiner 107. The first output matching network and the second output matching network are both high-bandwidth LC matching networks formed by lumped devices.

The output power combiner 107 is configured to receive two radio frequency signals having a same amplitude and a phase difference of 90°, and then combine the two radio frequency signals into a radio frequency signal for output. This is implemented by a 3 dB distributed orthogonal coupler formed by on-substrate metal coupling lines.

In the balanced radio frequency power amplifier provided by the embodiment of the present disclosure, when the radio frequency signal input end receives an input radio frequency signal, the driving-stage power unit 101 drives and amplifies the input radio frequency signal, and then outputs the amplified radio frequency signal to the inter-stage power divider 102. The inter-stage power divider 102 divides the radio frequency signal into two radio frequency signals having a same amplitude and a phase difference of 90°. The radio frequency signal having a phase of +45° (in-phase) is outputted to the main path power amplifier 103, and the radio frequency signal having a phase of -45° (quadrature-phase) is outputted to the auxiliary path power amplifier 104. After the two radio frequency signals having a phase difference of 90° are separately amplified by the main path power amplifier 103 and the auxiliary path power amplifier 104, the two amplified radio frequency signals separately enter two input ends of the output power combiner 107 via the first output matching network A105 and the second output matching network B106. The output power combiner 107 combines the two radio frequency signals into one radio frequency signal and outputs the radio frequency signal via the radio frequency signal output end.

The following describes in detail aspects such as a compositional structure, a working principle, and circuit performance of a balanced radio frequency power amplifier provided by the present disclosure by using specific embodiments.

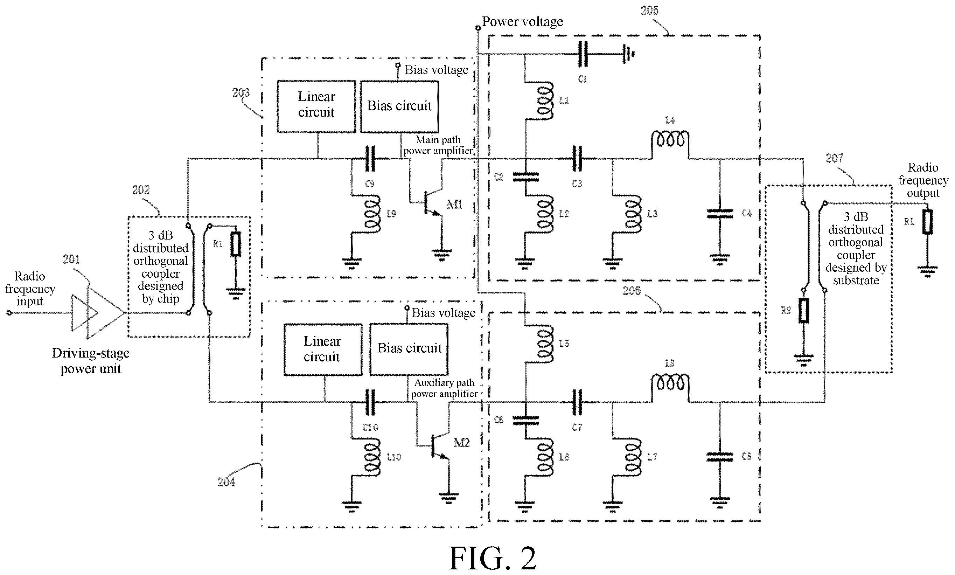

As shown in FIG. 2, in one embodiment of the present disclosure, a balanced radio frequency power amplifier includes a driving-stage power unit 201, an inter-stage power divider 202, a main path power amplifier 203, an auxiliary path power amplifier 204, a first output matching network A205, a second output matching network B206, and an output power combiner 207. Each unit circuit will be described in detail below.

The driving-stage power unit 201 may include a single-stage power unit or a two-stage power unit. An input end of the driving-stage power unit is connected to a radio frequency signal input end, and an output end of the driving-stage power unit is connected to an input end of the inter-stage power divider 202. The driving-stage power unit is mainly configured to drive and amplify an input radio frequency signal.

The inter-stage power divider 202 includes a 3 dB distributed orthogonal coupler formed by on-chip metal coupling lines, and has four terminals. The first terminal is an input end, which is connected to an output end of the driving-stage power unit 201. The second terminal is a ground end, which is connected to a ground potential end via a first resistor R1. The third terminal is an in-phase output end, which is connected to an input end of the main path power amplifier 203. The fourth terminal is a quadrature-phase output end, which is connected to an input end of the auxiliary path power amplifier 204.

The inter-stage power divider 202 is mainly configured to receive an input radio frequency signal, and then generate two output radio frequency signals having equal amplitudes and a phase difference of 90°. The 3 dB distributed orthogonal coupler is formed by using a chip metal laminated coupling structure or a same-layer coupling structure, and a coupling coefficient of the coupler may further be changed by adding a capacitor device. The circuit structure thereof has excellent performance such as a large bandwidth, a small area, and convergence of port impedance. The disadvantage is that the insertion loss is slightly larger, but is acceptable in a mobile communication terminal.

The main path power amplifier 203 includes a first capacitor C9, a first inductor L9, a first transistor M1, a linear circuit, and a bias circuit. An in-phase output end of the inter-stage power divider 202 is connected to the input end of the main path power amplifier 203. The input end of the main path power amplifier 203 is connected to the first capacitor C9, the first inductor L9, and the linear circuit. The other end of the first inductor L9 is connected to a ground potential end. The other end of the first capacitor C9 is connected to a gate of the first transistor M1 and the bias circuit. A source of the first transistor M1 is connected to the ground potential end. A drain of the first transistor M1 is connected to an output end of the main path power amplifier 203. The output end of the main path power amplifier 203 is connected to an input end of the first output matching network A205. The first capacitor C9 and the first inductor L9 form an input matching network.

The auxiliary path power amplifier 204 includes a second capacitor C10, a second inductor L10, a second transistor M2, a linear circuit, and a bias circuit. A quadrature-phase output end of the inter-stage power divider 202 is connected to the input end of the auxiliary path power amplifier 204. The input end of the auxiliary path power amplifier 204 is connected to the second capacitor C10, the second inductor L10, and the linear circuit. The other end of the second inductor L10 is connected to a ground potential end. The other end of the second capacitor C10 is connected to a gate of the second transistor M2 and the bias circuit. A source of the second transistor M2 is connected to the ground potential end. A drain of the second transistor M2 is connected to an output end of the auxiliary path power amplifier 204. The output end of the auxiliary path power amplifier 204 is connected to an input end of the second output matching network B206. The second capacitor C10 and the second inductor L10 form an input matching network.

The main path power amplifier 203 and the auxiliary path power amplifier 204 have symmetrical circuit structures, and are both single-stage amplifiers. Linear circuits having same or similar structures and parameters are disposed at the input ends. Amplification transistor areas are equal or approximate, and a bias current is provided by the bias circuit having same or similar structures and parameters. The input matching networks have a same structure and parameters.

In one embodiment of the present disclosure, the linear circuit provides three circuit structural solutions. The linear circuit is formed by connecting a resistor in series with an array of diodes connected in parallel forwardly or reversely. The resistor is connected to an input end of an amplifier circuit and is mainly configured to optimize linearity of a radio frequency power amplifier circuit.

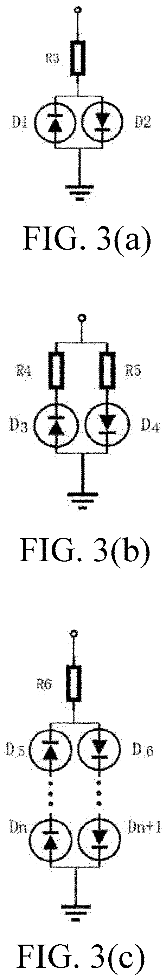

As shown in FIG. 3(a), the linear circuit of the first solution includes a third resistor R3, a first diode D1, and a second diode D2. One end of the third resistor R3 is connected to the input end of the power amplifier circuit. After the first diode D1 and the second diode D2 are connected in parallel forwardly or reversely, one end is connected to the other end of the third resistor R3, and the other end is connected to the ground potential end.

As shown in FIG. 3(b), the linear circuit of the second solution includes a fourth resistor R4, a fifth resistor R5, a third diode D3, and a fourth diode D4. The fourth resistor R4 is connected to a negative electrode of the third diode D3. The fifth resistor R5 is connected to a positive electrode of the fourth diode D4. The other end of the fourth resistor R4 is connected to the other end of the fifth resistor R5 in parallel, and then is connected to the input end of the power amplifier circuit. A positive electrode of the third diode D3 is connected to a negative electrode of the fourth diode D4 in parallel, and then is connected to the ground end.

As shown in FIG. 3(c), the linear circuit of the third solution includes a sixth resistor R6, a fifth diode D5, a sixth diode D6 ..., an $n^{th}$ diode Dn, and an $(n+1)^{th}$ diode Dn+1, where n is an odd number greater than or equal to 7. Descriptions are provided below by using an example in which n is 9. There are a total of 6 diodes in the circuit, which are respectively a fifth diode D5, a sixth diode D6, a seventh diode D7, an eighth diode D8, a ninth diode D9, and a twelfth diode D10. The fifth diode D5, the seventh diode D7, and the ninth diode D9 are sequentially connected in series with the positive and negative electrodes to form a first branch. The sixth diode D6, the eighth diode D8, and the twelfth diode D10 are sequentially connected in series with the positive and negative electrodes to form a second branch. A negative electrode of the first branch is connected in parallel to a positive electrode of the second branch and then is connected to the input end of the power amplifier circuit. A positive electrode of the first branch is connected in parallel to a negative electrode of the second branch and then is connected to the ground potential end.

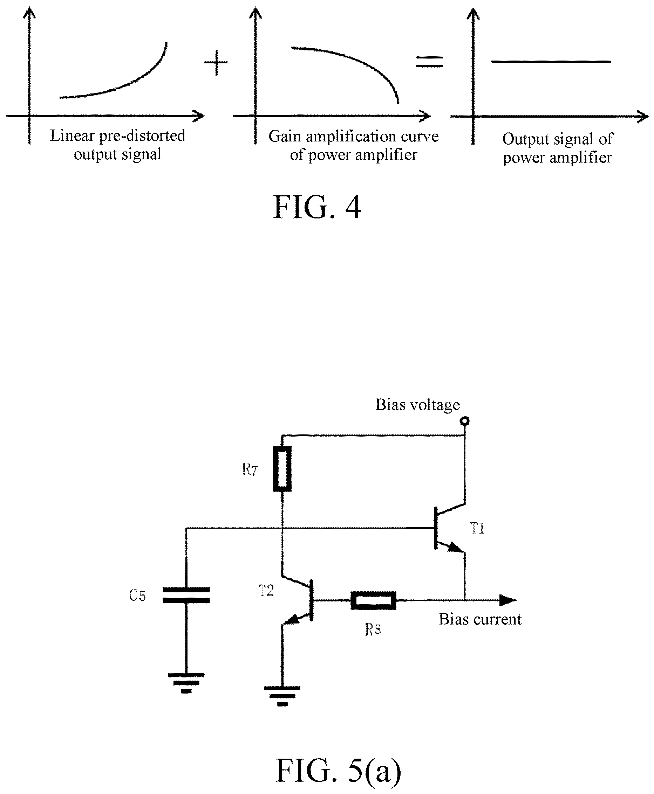

A working principle of the linear circuit is shown in FIG. 4. When the power amplifier circuit inputs a radio frequency signal, waveform shape is performed on the input radio frequency signal by means of a rectification effect of the diodes connected in parallel forwardly or reversely, to pre-distort the input radio frequency signal. After the pre-distorted radio frequency signal is amplified by a power amplifier transistor, distortion of the power amplifier transistor is used to compensate for pre-distortion of the input radio frequency signal caused by the linear circuit. Finally, a distortion degree of the radio frequency signal at an output end of the power amplifier circuit is reduced, and gain distortion and phase distortion are improved. Therefore, the power amplifier circuit can obtain relatively good linearity.

In the solution designs of the foregoing three linear circuit structures, the linear circuit of the second solution adjusts a rectification effect and a pre-distortion amplitude by changing a resistance value or a resistance connection mode. The linear circuit of the third solution reduces the pre-distortion amplitude by increasing the number of diodes connected in series. Furthermore, the pre-distortion amplitude can be enhanced by increasing the number of diodes connected in parallel or the area of the diodes.

In one embodiment of the present disclosure, as shown in FIG. 5(a), the bias circuit includes a seventh resistor R7, an eighth resistor R8, a third capacitor C5, a third transistor T1, and a fourth transistor T2. A drain of the third transistor T1 and the seventh resistor R7 are connected and then jointly to a bias voltage end. A gate of the third transistor T1 is connected to the other end of the seventh resistor R7, the third capacitor C5, and a drain of the fourth transistor T2. The other end of the third capacitor C5 is connected to the ground potential end. A source of the fourth transistor T2 is connected to the ground potential end. A gate of the fourth transistor T2 is connected to a source of the third transistor T1 and a bias current output end via the eighth resistor R8.

In the structure of the bias circuit, the third transistor T1 is an emitter follower transistor, and the fourth transistor T2 is a feedback amplifier transistor. The bias circuit implements a low-impedance output, provides a bias current to a main power transistor of the power amplifier circuit, improves linearity of a broadband signal of the power amplifier circuit, and improves a capability of processing the broadband signal of the power amplifier circuit.

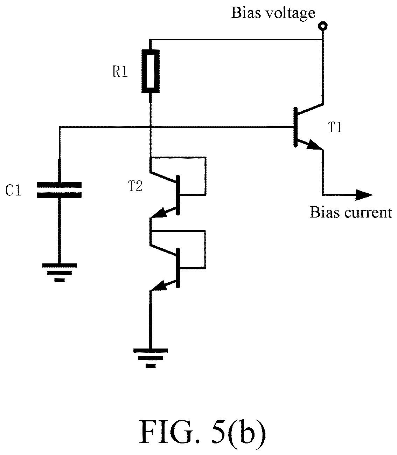

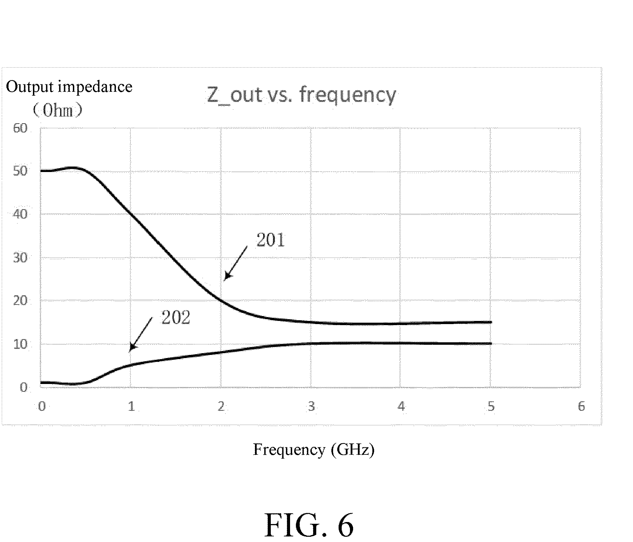

To verify a beneficial effect of the technical solution of the bias circuit provided in the embodiment of the present disclosure, the inventor separately performs simulation tests of output impedance on the technical solution provided in the present disclosure and the bias circuit of the existing technical solution shown in FIG. 5(b). A simulation test result is shown in FIG. 6. In FIG. 6, a horizontal coordinate is frequency, a vertical coordinate is impedance, curve 202 is the output impedance of the bias circuit in the technical solution provided in the present disclosure, and curve 201 is the output impedance of the bias circuit in the existing technical solution. It can be seen from FIG. 6 that, in a low-frequency region less than 200 MHz, the output impedance of the bias circuit in the technical solution provided by the present disclosure is very small and approaches 0 omega, while the output impedance of the bias circuit in the existing technical solution is greater than 50 omega. Therefore, in the technical solution provided by the present disclosure, an effect that the bias circuit implements a low-impedance output is very clear.

It should be noted that the bias circuit provided in the embodiment of the present disclosure may alternatively use other similar different circuit structures to implement a low-impedance output and provide a bias current to the power amplifier circuit.

The first output matching network A205 includes a fourth capacitor C1, a fifth capacitor C2, a sixth capacitor C3, a seventh capacitor C4, a third inductor L1, a fourth inductor L2, a fifth inductor L3, and a sixth inductor L4. The output end of the main path power amplifier 203 is connected to the input end of the first output matching network A205. The input end of the first output matching network A205 is separately connected to the fifth capacitor C2, the sixth capacitor C3, and the third capacitor L1. The other end of the fifth capacitor C2 is connected to the fourth inductor L2, and the other end of the fourth inductor L2 is connected to the ground potential end. The other end of the third inductor L1 is connected to a power voltage end and the fourth capacitor C1, and the other end of the fourth capacitor C1 is connected to the ground potential end. The other end of the sixth capacitor C3 is connected to the fifth inductor L3 and the sixth inductor L4. The other end of the fifth inductor L3 is connected to the ground potential end. The other end of the sixth inductor L4 is connected to the seventh capacitor C4 and the output end of the first output matching network A205. The other end of the seventh capacitor C4 is connected to the ground potential end. The output end of the first output matching network A205 is connected to an in-phase input end of the output power combiner 207.

The fourth capacitor C1 is a power filter capacitor. The fifth capacitor C2 and the fourth inductor L2 are connected in series to form a resonance network for adjusting a harmonic impedance, where a variable capacitor may be used as the fifth capacitor C2. The sixth capacitor C3, the seventh capacitor C4, the fifth inductor L3, and the sixth inductor L4 form a CLLC-type impedance matching network. It should be noted that in other embodiments of the present disclosure, an LCCL-type impedance matching network may alternatively be used as an impedance matching network.

The second output matching network B206 includes an eighth capacitor C6, a ninth capacitor C7, a tenth capacitor C8, a seventh inductor L5, an eighth inductor L6, a ninth inductor L7, and a tenth inductor L8. The output end of the auxiliary path power amplifier 204 is connected to the input end of the second output matching network B206. The input end of the second output matching network B206 is separately connected to the eighth capacitor C6, the ninth capacitor C7, and the seventh inductor L5. The other end of the eighth capacitor C6 is connected to the eighth inductor L6. The other end of the eighth inductor L6 is connected to the ground potential end. The other end of the seventh inductor L5 is connected to the power voltage end. The other end of the ninth capacitor C7 is connected to the ninth inductor L7 and the tenth inductor L8. The other end of the ninth inductor L7 is connected to the ground potential end. The other end of the tenth inductor L8 is connected to the tenth capacitor C8 and the output end of the second output matching network B206. The other end of the tenth capacitor C8 is connected to the ground potential end. The output end of the second output matching network B206 is connected to a quadrature-phase input end of the output power combiner 207.

The eighth capacitor C6 and the eighth inductor L6 are connected in series to form a resonance network for adjusting a harmonic impedance, where a variable capacitor may be used as the eighth capacitor C6. The ninth capacitor C7, the tenth capacitor C8, the ninth inductor L7, and the tenth inductor L8 form a CLLC-type impedance matching network. It should be noted that in other embodiments of the present disclosure, an LCCL-type impedance matching network may alternatively be used as an impedance matching network.

The first output matching network A205 and the second output matching network B206 are both high-bandwidth LC matching networks formed by lumped devices, and are mainly configured to separately match an output impedance of the main path power amplifier 203 and an output impedance of the auxiliary path power amplifier 204 to a feature impedance of the output power combiner 207.

The output power combiner 207 includes a 3 dB distributed orthogonal coupler formed by on-substrate metal coupling lines, and has four terminals. The first terminal is an in-phase input end, which is connected to the output end of the first output matching network A205. The second terminal is a quadrature-phase input end, which is connected to the output end of the second output matching network B206. The third terminal is an output end, which is connected to the output end of the radio frequency power amplifier circuit. The fourth terminal is a ground end, which is connected to the ground potential end via a second resistor R2.

The output power combiner 207 is mainly configured to receive two input radio frequency signals having a same amplitude and a phase difference of 90°, and then combine the two input radio frequency signals into a radio frequency signal for output. The 3 dB distributed orthogonal coupler is formed by using a substrate metal laminated coupling structure or a same-layer coupling structure. Since the thickness of substrate metal is much greater than that of chip metal and the electrical conduction of a copper substrate is relatively good, the insertion loss can be optimized. The circuit structure thereof has excellent performance such as a large bandwidth, a small insertion loss, and convergence of port impedance. The disadvantage is that the area is slightly larger, but is acceptable in a mobile communication terminal.

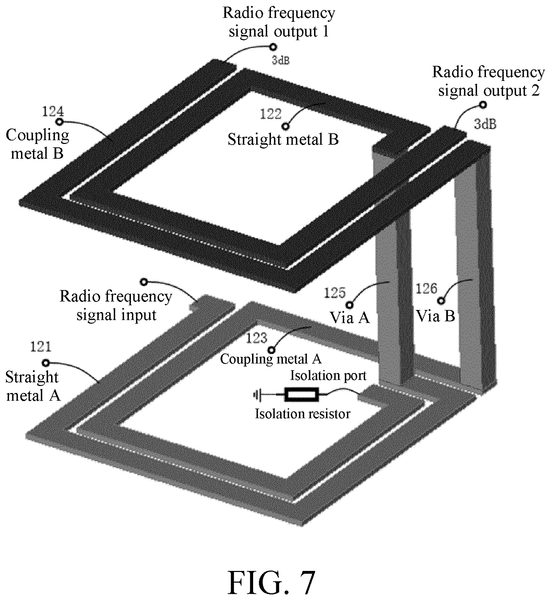

FIG. 7 shows a 3 dB distributed orthogonal coupler designed by using a laminated circuit. The 3 dB distributed orthogonal coupler in FIG. 7 is an inter-stage power divider structure formed by on-chip metal coupled lines, and has one signal input end and two signal output ends. When the 3 dB distributed orthogonal coupler designed by using the laminated circuit is configured for the output power combiner, the coupler is formed by on-substrate metal coupling lines, and has two signal input ends and one signal output end.

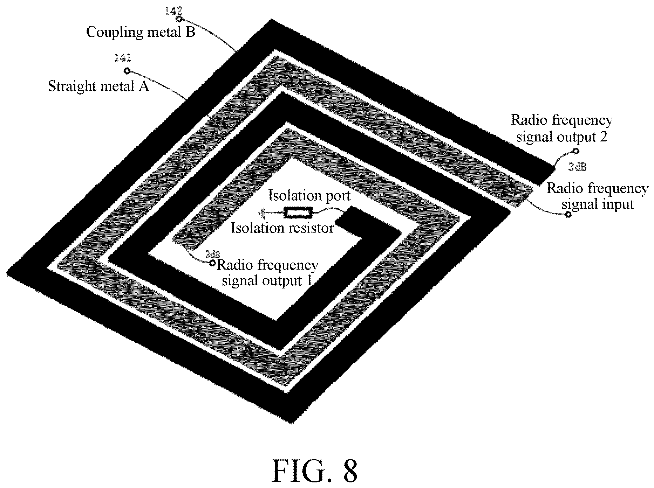

FIG. 8 shows a 3 dB distributed orthogonal coupler designed by using a same-layer circuit. The 3 dB distributed orthogonal coupler in FIG. 8 is an inter-stage power divider structure formed by on-chip metal coupled lines, and has one signal input end and two signal output ends. When the 3 dB distributed orthogonal coupler designed by using the same-layer circuit is configured for the output power combiner, the coupler is formed by on-substrate metal coupling lines, and has two signal input ends and one signal output end.

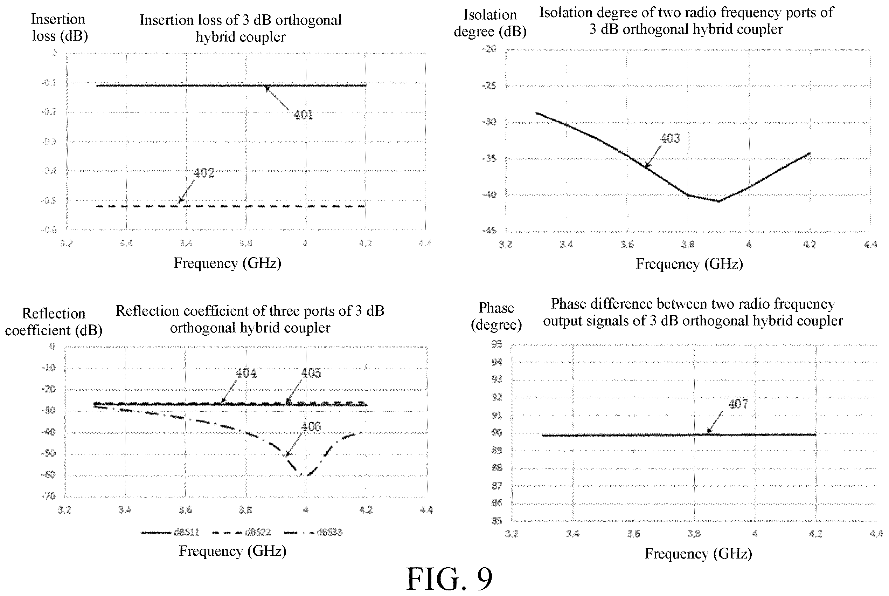

To verify beneficial effects of the output power combiner technical solution provided in the embodiment of the present disclosure, the inventor performs simulation tests on performance indicators such as an insertion loss, an isolation degree, and a reflection coefficient within an n77 working band. A test result is shown in FIG. 9. Curve 401 represents an insertion loss of a 3 dB distributed orthogonal coupler designed by using substrate metal, which is approximately 0.1 dBc. Curve 402 represents an insertion loss of a 3 dB distributed orthogonal coupler designed by using chip metal, which is approximately 0.5 dBc. Compared with the design using chip metal, the insertion loss of the 3 dB distributed orthogonal coupler designed by using substrate metal is reduced by approximately 0.4 dBc. Curve 403 represents an isolation degree of two input radio frequency ports, which are both less than -25 dBc. Curves 404, 405, and 406 are reflection coefficients of three radio frequency ports, which are all less than -25 dBc, indicating that port impedance is convergent and the reflection coefficient is small. Curve 407 represents a phase difference between two input radio frequency ports, where the phase difference keeps at 90°.

It can be seen from the foregoing simulation test result that, within the n77 working band, the excellent effects of the performance indicators such as the insertion loss, the isolation degree, the reflection coefficient, and the phase difference of the output power combiner formed by the 3 dB distributed orthogonal coupler designed by using substrate metal provided in the embodiment of the present disclosure are very clear.

The foregoing describes each unit circuit in the balanced radio frequency power amplifier provided in the embodiment of the present disclosure in detail. The following analyzes and describes transmission power and efficiency of the balanced radio frequency power amplifier when the antenna standing wave ratio changes.

In the existing technology, a saturation power $P_{RF\_SAT}$ of a single-end radio frequency power amplifier and efficiency $\eta_{RF\_rated}$ at a back-off power are:

$$P_{RF\_SAT} = \frac{V_{CC} \cdot V_{CC}}{2 \cdot R_L} \qquad (1)$$

$$\eta_{RF\_rated} = \frac{\sqrt{2 \cdot R_L \cdot P_{RF\_rated}}}{V_{CC}} \qquad (2)$$

where $P_{RF\_rated}$ is power at a back-off point of the power amplifier; $V_{CC}$ is a power voltage; and $R_L$ is a power amplifier load line.

It can be seen from Formula 1 and Formula 2 that, when the power amplifier load line $R_L$ increases, the efficiency $\eta_{RF\_rated}$ at the back-off power will be increased, but the saturation power $P_{RF\_SAT}$ of the power amplifier will be reduced. When the power amplifier load line $R_L$ is reduced, the saturation power $P_{RF\_SAT}$ of the power amplifier will be increased, but the efficiency $\eta_{RF\_rated}$ at the back-off power will be reduced.

A mathematical expression of an antenna standing wave ratio VSWR is:

$$VSWR = \left| \frac{R_{ANT} + R_L}{R_{ANT} - R_L} \right| \qquad (3)$$

where $R_{ANT}$ is an antenna load line; and $R_L$ is the power amplifier load line, which generally has a design value of $R_L = 50\,\Omega$.

When the antenna load line $R_{ANT}$ is equal to the power amplifier load line $R_L$, to be specific, the antenna standing wave ratio VSWR is 1, the transmission power and transmitting efficiency of the single-end power amplifier are optimal. When the antenna load line $R_{ANT}$ is not equal to the power amplifier load line $R_L$, to be specific, in a case that the antenna standing wave ratio VSWR is greater than 1, the transmission power or transmitting efficiency of the power amplifier will be changed and reduced, and the reduction in the transmission power will lead to the failure of the transmission indicators. To meet the requirements of the transmission power under the condition of the antenna standing wave ratio VSWR < 3, the single-end power amplifier is generally designed to meet the requirements of the transmission power under the condition of the antenna standing wave ratio VSWR < 3 by increasing the transmission power under the condition of the antenna standing wave ratio VSWR = 1. This method reduces the transmitting efficiency of the power amplifier, thereby increasing heat generation of a device and shortening a standby time.

When the antenna standing wave ratio VSWR changes, the output power $G_A$ of the balanced radio frequency power amplifier provided by the embodiment of the present disclosure is:

$$G_A = 20 \cdot log\left(e^{-j2\theta}\right) = 0\ dBc \qquad (4)$$

where $2\theta$ is a phase of a transmission arm of the coupler.

It can be seen from Formula 4 that, when the antenna standing wave ratio VSWR changes, the output power of the balanced radio frequency power amplifier will not be affected, and the output power can be kept constant.

The load line impedances of the two power amplification units of the balanced radio frequency power amplifier are separately:

$$Z_A = Z_0 \cdot \left( \frac{1 + |\Gamma_L| \cdot e^{j(\theta_L - 2\theta)}}{1 - |\Gamma_L| \cdot e^{j(\theta_L - 2\theta)}} \right) \qquad (5)$$

$$Z_B = Z_0 \cdot \left( \frac{1 + j \cdot |\Gamma_L| \cdot e^{j(\theta_L - 2\theta)}}{1 - j \cdot |\Gamma_L| \cdot e^{j(\theta_L - 2\theta)}} \right) \qquad (6)$$

where $Z_A$ is the load line impedance of the main path power amplification unit; $Z_B$ is the load line impedance of the auxiliary path power amplification unit; $Z_0$ is the system feature impedance, which is generally 50 omega; $\Gamma_L$ is a transmission coefficient of an antenna; and $\theta_L$ is an antenna phase.

A mathematical relationship between the antenna transmission coefficient $\Gamma_L$ and the antenna standing wave ratio VSWR is:

$$\Gamma_L = \frac{VSWR - 1}{VSWR + 1} \qquad (7)$$

It can be seen from Formula 5 and Formula 6 that, the load line impedance of the power amplification unit changes with the change of the antenna phase, which will directly affect the working current and output power of the power amplifier. The performance indicators of the balanced radio frequency power amplifier provided in the embodiment of the present disclosure are verified below by using simulation tests such as a load line impedance, an output power, and a working current.

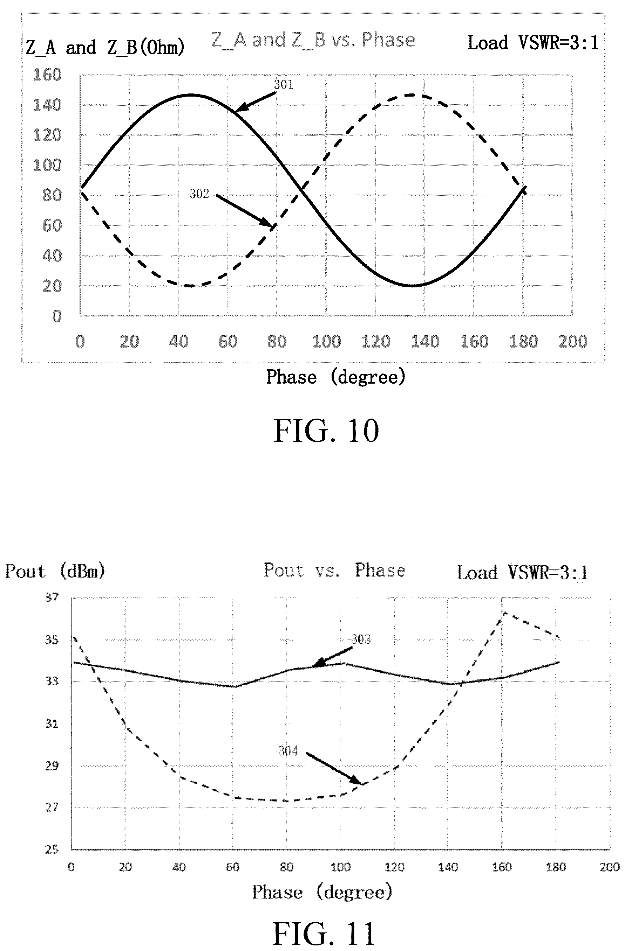

As shown in FIG. 10, under the condition that the antenna standing wave ratio *VSWR* is 3, the load line impedances of the two power amplification units of the balanced radio frequency power amplifier provided in the embodiment of the present disclosure compensate for each other with the change of the antenna phase. In FIG. 10, curve 301 represents the load line impedance of the main path power amplification unit, and curve 302 represents the load line impedance of the auxiliary path power amplification unit. The two load impedances change alternately, so that the output power and output current of the two power amplification units also change alternately, and an effect of mutual compensation is presented.

In the foregoing simulation test, when the antenna phase changes within the range of 0° to 180°, specific changes of the impedance, the current, and the output power of the main path power amplification unit and the auxiliary path power amplification unit of the balanced radio frequency power amplifier provided in the embodiment of the present disclosure are as follows:

When the antenna phase angle is 0°, 90°, or 180°, the main path load impedance and the auxiliary path load impedance are equal. To be specific, $Z_A = Z_B = 81\,\Omega$. In this case, the current and output power of the main path power amplification unit and the auxiliary path power amplification unit are separately equal. The output power of the output end of the balanced radio frequency power amplifier is the sum of the output power of the main path power amplification unit and the auxiliary path power amplification unit.

When the antenna phase angle deviates from 0°, 90°, or 180°, the main path load impedance is $Z_A = 142\,\Omega$ in an example in which the antenna phase angle is 45°. Compared with the antenna phase angle of 0°, 90°, or 180°, the antenna phase angle is increased by 61 omega. The auxiliary path load impedance is $Z_B = 20\,\Omega$. Compared with the antenna phase angle of 0°, 90°, or 180°, the antenna phase angle is reduced by 61 omega. In this case, the current and output power of the main path power amplification unit are correspondingly reduced compared with the antenna phase angle of 0°, 90°, or 180°, the current and output power of the auxiliary path power amplification unit are correspondingly increased compared with the antenna phase angle of 0°, 90°, or 180°, and a reduction amount of the former is equal to an increase amount of the latter. Therefore, the output power of the output end of the balanced radio frequency power amplifier, i.e. the sum of the output power of the main path power amplification unit and the auxiliary path power amplification unit, keeps unchanged.

As shown in FIG. 11, under the condition that the antenna standing wave ratio *VSWR* is 3, as the antenna phase changes, the output power of the balanced radio frequency power amplifier provided in the embodiment of the present disclosure changes by approximately 1 dB.In FIG. 11, curve 303 is a curve of change of output power of a balanced power amplifier with an antenna phase according to the present disclosure. Curve 304 is a curve of change of output power of a single-end power amplifier with an antenna phase in the existing technology, where the change of the output power is approximately 8 dB. Compared with the existing technology, the balanced radio frequency power amplifier provided by the present disclosure can well keep a stable output power when the antenna phase changes.

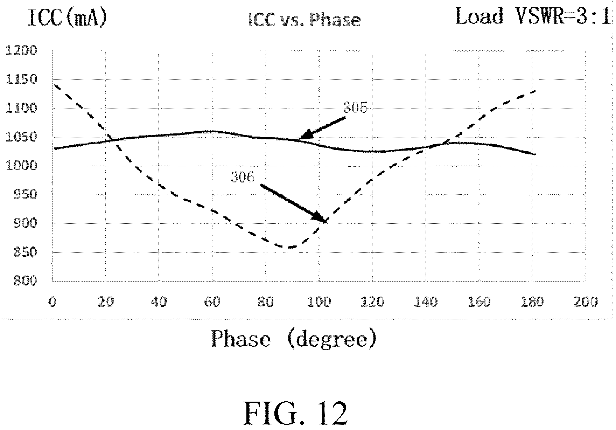

As shown in FIG. 12, under the condition that the antenna standing wave ratio *VSWR* is 3, as the antenna phase changes, the working current of the balanced radio frequency power amplifier provided in the embodiment of the present disclosure changes by approximately 30 mA.In FIG. 12, curve 305 is a curve of change of working current of a balanced power amplifier with an antenna phase according to the present disclosure. Curve 306 is a curve of change of working current of a single-end power amplifier with an antenna phase in the existing technology, where the change of the working current is approximately 300 mA. Compared with the existing technology, the balanced radio frequency power amplifier provided by the present disclosure can well keep a stable working current when the antenna phase changes.

It can be seen from the foregoing analysis and simulation test results that, the balanced radio frequency power amplifier provided by the present disclosure can effectively improve the transmission power and transmitting efficiency in a case that the antenna standing wave ratio changes.

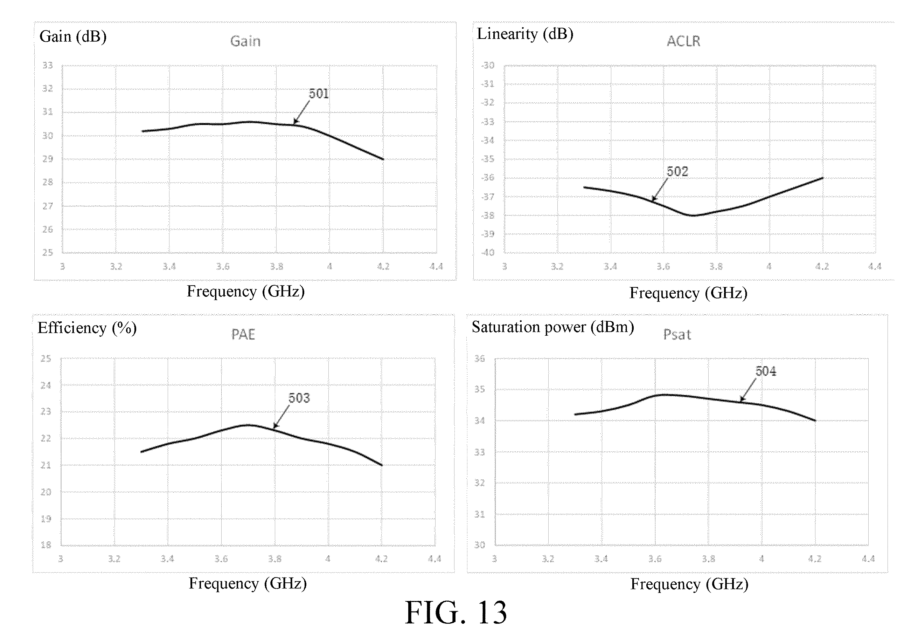

In addition, the inventor further performs simulation tests on multiple performance indicators such as gain, efficiency, and linearity in the n77 band of the balanced radio frequency power amplifier provided in the embodiment of the present disclosure. A simulation test result is shown in FIG. 13. Curve 501 represents a gain curve of the balanced radio frequency power amplifier, where a gain deviation is less than $\pm 1$ dB within the n77 band. Curve 502 represents a linearity curve of the balanced radio frequency power amplifier, where a linearity deviation is less than $\pm 2$ dB within the n77 band. Curve 503 represents an efficiency curve of the balanced radio frequency power amplifier, where an efficiency deviation is less than 2% within the n77 band. Curve 504 represents a saturation power curve of the balanced radio frequency power amplifier, where a saturation power deviation is less than $\pm 1$ dB within the n77 band. It can be seen from the simulation test result that, the balanced radio frequency power amplifier provided in the embodiment of the present disclosure can meet the system requirements in gain, efficiency, linearity, and other performances within the n77 band.

The embodiment of the present disclosure further provides a radio frequency front-end module. The radio frequency front-end module includes the balanced radio frequency power amplifier provided in the embodiment of the present disclosure, and may be used as an important part of a mobile communication terminal in a wireless communication system. The radio frequency front-end module includes a substrate, at least one radio frequency power amplifier chip, at least one power supply and control chip, a group of output matching networks formed by lumped surface-mounted components, and an output power combiner formed by on-substrate metal wires. The radio frequency power amplifier chip includes at least one driving-stage power unit, an inter-stage power divider, a main path power amplifier, and an auxiliary path power amplifier.

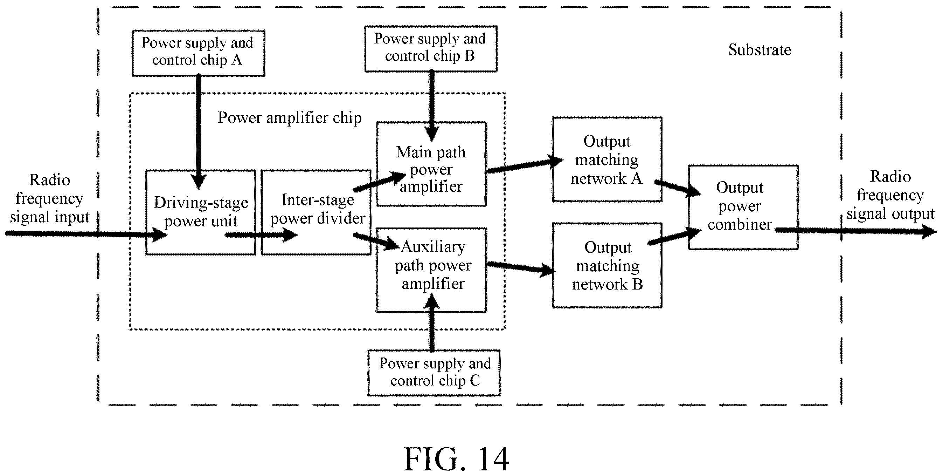

As shown in FIG. 14, in the radio frequency front-end module, a layout mode of the balanced radio frequency power amplifier is that: the driving-stage power unit, the inter-stage power divider, the main path power amplifier, and the auxiliary path power amplifier are all disposed on the radio frequency power amplifier chip. A power supply and control chip A, a power supply and control chip B, a power supply and control chip C, a first output matching network A, a second output matching network B, and the output power combiner are all disposed on the substrate. A power supply and control line A provides a power and control signal for the driving-stage power unit. A power supply and control line B provides a power and control signal for the main path power amplifier. A power supply and control line C provides a power and control signal for the auxiliary path power amplifier. The radio frequency power amplifier chip and the substrate are packaged forwardly. The output ends of the main path power amplifier and the auxiliary path power amplifier are separately bonded to the first output matching network A and the second output matching network B via a metal wire. FIG. 14 further provides a flow direction of an input radio frequency signal. As shown by an arrow, the radio frequency input signal enters the radio frequency power amplifier chip from the input end of the driving-stage power unit, and finally is transmitted out from the output end of the output power combiner.

In addition, it should be noted that in other embodiments of the present disclosure, the power supply and control chip A, the power supply and control chip B, and the power supply and control chip C may be disposed on a same chip, or may be three completely independent chips or may be integrated into one or two chips. The radio frequency power amplifier chip and the substrate may alternatively be packaged reversely. The output ends of the main path power amplifier and the auxiliary path power amplifier are directly connected to the first output matching network A and the second output matching network B via a copper pillar or a soldering ball. Similarly, to save the area, the output power combiner may be disposed on a side of or below the first output matching network A and the second output matching network B.

In addition, the balanced radio frequency power amplifier provided in the embodiment of the present disclosure may alternatively be used in an electronic device as an important part of a communication component. The electronic device herein refers to a computer device that may be used in a mobile environment and supports various communication standards such as GSM, EDGE, TD_SCDMA, TDD_LTE, FDD_LTE, and 5G, and includes a mobile phone, a notebook computer, a tablet computer, and an in-vehicle computer. Furthermore, the technical solutions provided in the present disclosure are also applicable to an application scenario of another radio frequency front-end module, such as a communication base station or an intelligent connected vehicle.

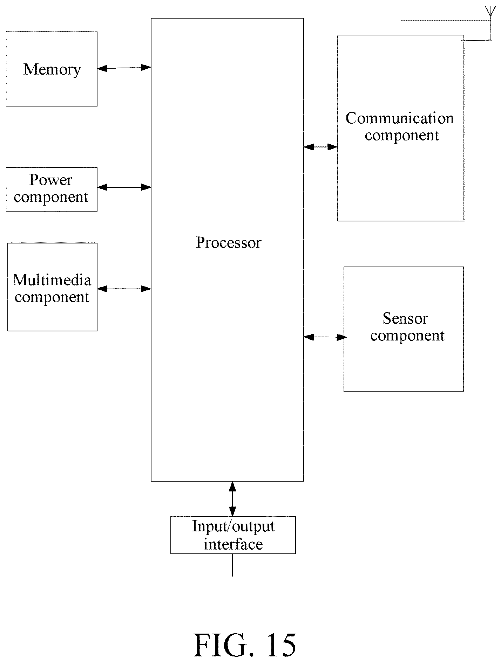

As shown in FIG. 15, the electronic device includes at least a processor and a memory, and may further include a communication component, a sensor component, a power component, a multimedia component, and an input/output interface according to an actual requirement. The memory, the communication component, the sensor component, the power component, the multimedia component, and the input/output interface are all connected to the processor. The memory may be a static random access memory (SRAM), an electrically erasable programmable read-only memory (EEPROM), an erasable programmable read-only memory (EPROM), a programmable read-only memory (PROM), a read-only memory (ROM), a magnetic memory, a flash memory, or the like. The processor may be a central processing unit (CPU), a graphics processing unit (GPU), a field programmable gate array (FPGA), an application-specific integrated circuit (ASIC), a digital signal processing (DSP) chip, or the like. Other sensor components, power components, multimedia components, and the like may all be implemented by using existing conventional devices. This is not specifically described herein.

Compared with the existing technology, the balanced radio frequency power amplifier provided by the present disclosure has the advantages that a symmetrical balance design is used for the main path power amplifier and the auxiliary path power amplifier, so that the impact of the change in the antenna voltage standing wave ratio on the transmission power and the transmitting efficiency is overcome to the greatest extent. Moreover, a 3 dB distributed orthogonal coupler is used for the inter-stage power divider and the output power combiner which are separately implemented on a chip and a substrate, so that performance indicators of the radio frequency power amplifier such as the area size, the bandwidth, the insertion loss, and the transmitting efficiency are optimally balanced and optimized. At the same time, by adopting the technical solution of a linear circuit, the gain distortion and phase distortion of a power amplifier are improved, and better linearity is obtained. By adopting the technical solution of a bias circuit with low impedance output, the linearity of a broadband signal of a power amplifier circuit is improved, and the processing ability of the broadband signal is improved. Therefore, the balanced radio frequency power amplifier provided by the present disclosure has beneficial effects such as ingenious and proper circuit design, high flexibility, and excellent circuit performance, and is more in line with the requirements of technical performance indicators of a 5G communication system.

The foregoing describes in detail the balanced radio frequency power amplifier, the radio frequency front-end module, and the electronic device provided by the present disclosure. Any obvious change made by a person of ordinary skill in the art without departing from the essence of the present disclosure shall fall within the protection scope of the present disclosure.

**Claims**

1. A balanced radio frequency power amplifier, comprising a driving-stage power unit, an inter-stage power divider, a main path power amplifier, an auxiliary path power amplifier, a first output matching network (A), a second output matching network (B), and an output power combiner, wherein

   an input end of the driving-stage power unit receives an input radio frequency signal, and an output end is connected to an input end of the inter-stage power divider and is configured to drive and amplify the input radio frequency signal;

   an in-phase output end of the inter-stage power divider is connected to an input end of the main path power amplifier, and a quadrature-phase output end of the inter-stage power divider is connected to an input end of the auxiliary path power amplifier and is configured to generate two radio frequency signals having equal amplitudes and a phase difference of 90°;

   an output end of the main path power amplifier is connected to an input end of the first output matching network (A), and an output end of the auxiliary path power amplifier is connected to an input end of the second output matching network (B); an output end of the first output matching network (A) is connected to an in-phase input end of the output power combiner, and an output end of the second output matching network (B) is connected to a quadrature-phase input end of the output power combiner; and

   the output power combiner is configured to receive two radio frequency signals having a same amplitude and a phase difference of 90°, and combine the two radio frequency signals into an output radio frequency signal.

2. The balanced radio frequency power amplifier according to claim 1, wherein
   the inter-stage power divider comprises a 3 dB distributed orthogonal coupler formed by on-chip metal coupling lines, a chip metal laminated coupling structure or a same-layer coupling structure being used.

3. The balanced radio frequency power amplifier according to claim 1, wherein
   the output power combiner comprises a 3 dB distributed orthogonal coupler formed by on-substrate metal coupling lines, a substrate metal laminated coupling structure or a same-layer coupling structure being used.

4. The balanced radio frequency power amplifier according to claim 1, wherein
   the main path power amplifier comprises a first capacitor (C9), a first inductor (L9), a first transistor (M1), a linear circuit, and a bias circuit, wherein the input end of the main path power amplifier is connected to the first capacitor (C9), the first inductor (L9), and the linear circuit, the other end of the first inductor (L9) is connected to a ground potential end, the other end of the first capacitor (C9) is connected to a gate of the first transistor (M1) and the bias circuit, a source of the first transistor (M1) is connected to the ground potential end, and a drain of the first transistor (M1) is connected to the output end of the main path power amplifier; and the first capacitor (C9) and the first inductor (L9) form an input matching network.

5. The balanced radio frequency power amplifier according to claim 4, wherein

   the linear circuit is formed by connecting a resistor in series with an array of diodes connected in parallel forwardly and reversely, wherein the resistor is connected to an input end of a power amplifier circuit, and the diodes are connected to the ground potential end; and

   the linear circuit reduces a pre-distortion amplitude by increasing the number of diodes connected in series, and enhances the pre-distortion amplitude by increasing the number of diodes connected in parallel or the area of the diodes.

6. The balanced radio frequency power amplifier according to claim 4, wherein

   the bias circuit comprises a seventh resistor (R7), an eighth resistor (R8), a third capacitor (C5), a third transistor (T1), and a fourth transistor (T2), wherein a drain of the third transistor (T1) and the seventh resistor (R7) are connected and then jointly to a bias voltage end, a gate of the third transistor (T1) is connected to the other end of the seventh resistor (R7), the third capacitor (C5), and a drain of the fourth transistor (T2), the other end of the third capacitor (C5) is connected to the ground potential end, a source of the fourth transistor (T2) is connected to the ground potential end, and a gate of the fourth transistor (T2) is connected to a source of the third transistor (T1) and a bias current output end via the eighth resistor (R8); and

the third transistor (T1) is an emitter follower transistor, and the fourth transistor (T2) is a feedback amplification transistor.

7. The balanced radio frequency power amplifier according to claim 1, wherein

the first output matching network (A) and the second output matching network (B) are both high-bandwidth matching networks formed by lumped devices;

the first output matching network (A) comprises a fourth capacitor (C1), a fifth capacitor (C2), a sixth capacitor (C3), a seventh capacitor (C4), a third inductor (L1), a fourth inductor (L2), a fifth inductor (L3), and a sixth inductor (L4); the input end of the first output matching network (A) is separately connected to the fifth capacitor (C2), the sixth capacitor (C3), and the third capacitor (L1); the other end of the fifth capacitor (C2) is connected to the fourth inductor (L2), and the other end of the fourth inductor (L2) is connected to the ground potential end; the other end of the third inductor (L1) is connected to a power voltage end and the fourth capacitor (C1), and the other end of the fourth capacitor (C1) is connected to the ground potential end; the other end of the sixth capacitor (C3) is connected to the fifth inductor (L3) and the sixth inductor (L4), the other end of the fifth inductor (L3) is connected to the ground potential end, the other end of the sixth inductor (L4) is connected to the seventh capacitor (C4) and the output end of the first output matching network (A), and the other end of the seventh capacitor (C4) is connected to the ground potential end; wherein

the fourth capacitor (C1) is a power filter capacitor, and the first output matching network (A) and the second output matching network (B) jointly use one power filter capacitor;

the fifth capacitor (C2) and the fourth inductor (L2) are connected in series to form a resonance network for adjusting a harmonic impedance, and a variable capacitor is used as the fifth capacitor (C2); and

the sixth capacitor (C3), the seventh capacitor (C4), the fifth inductor (L3), and the sixth inductor (L4) form a CLLC-type impedance matching network.

8. The balanced radio frequency power amplifier according to claim 1, wherein when an antenna phase changes, a load line impedance of a main path power amplification unit and a load line impedance of an auxiliary path power amplification unit of the balanced radio frequency power amplifier change alternately, and output powers and output currents of the two power amplification units further change alternately, so that change amounts compensate for each other.

9. A radio frequency front-end module, implemented based on the balanced radio frequency power amplifier according to any one of claims 1 to 8, the radio frequency front-end module comprising a substrate, at least one radio frequency power amplifier chip, at least one output matching network, and an output power combiner, wherein

the driving-stage power unit, the inter-stage power divider, the main path power amplifier, and the auxiliary path power amplifier in the balanced radio frequency power amplifier are all integrated on the radio frequency power amplifier chip;

the radio frequency power amplifier chip and the substrate are packaged forwardly or reversely; and

the output ends of the main path power amplifier and the auxiliary path power amplifier are separately bonded to the first output matching network (A) and the second output matching network (B) via a metal wire, and are directly connected to the first output matching network (A) and the second output matching network (B) via a copper pillar or a soldering ball.

10. An electronic device, comprising the balanced radio frequency power amplifier according to any one of claims 1 to 8.

FIG. 1

FIG. 2

EP 4 597 837 A1

FIG. 3(a)

FIG. 3(b)

FIG. 3(c)

| Linear pre-distorted output signal | + | Gain amplification curve of power amplifier | = | Output signal of power amplifier |

FIG. 4

FIG. 5(a)

FIG. 5(b)

FIG. 6

Radio frequency
signal output 1

3dB

Radio frequency
signal output 2

124
Coupling
metal B

122
Straight metal B

3dB

Radio frequency
signal input

125
Via A

126
Via B

121
Straight
metal A

123
Coupling metal A

Isolation port

Isolation resistor

FIG. 7

FIG. 8

Insertion
loss (dB)

Insertion loss of 3 dB orthogonal
hybrid coupler

Frequency (GHz)

Isolation
degree (dB)

Isolation degree of two radio frequency ports of
3 dB orthogonal hybrid coupler

Frequency (GHz)

Reflection
coefficient (dB)

Reflection coefficient of three ports of 3 dB
orthogonal hybrid coupler

dBS11 ‐ ‐ ‐ dBS22 ‐ · ‐ dBS33

Frequency (GHz)

Phase
(degree)

Phase difference between two radio frequency
output signals of 3 dB orthogonal hybrid coupler

Frequency (GHz)

FIG. 9

Z_A and Z_B(Ohm)  Z_A and Z_B vs. Phase  Load VSWR=3:1

Phase (degree)

FIG. 10

Pout (dBm)  Pout vs. Phase  Load VSWR=3:1

Phase (degree)

FIG. 11

FIG. 12

FIG. 13

EP 4 597 837 A1

FIG. 14

FIG. 15

## INTERNATIONAL SEARCH REPORT

| International application No. |
| --- |
| **PCT/CN2023/119549** |

### A. CLASSIFICATION OF SUBJECT MATTER

H03F 3/20(2006.01)i; H03F1/42(2006.01)i; H03F 3/24(2006.01)i

According to International Patent Classification (IPC) or to both national classification and IPC

### B. FIELDS SEARCHED

Minimum documentation searched (classification system followed by classification symbols)

IPC:H03F

Documentation searched other than minimum documentation to the extent that such documents are included in the fields searched

Electronic data base consulted during the international search (name of data base and, where practicable, search terms used)

CNTXT, DWPI, ENTXT: 唯捷创芯, 射频, 放大器, 匹配网络, 功分器, 功率分配, 正交耦合器, 偏置, 线性, 电路, 主, 副, 辅, 基板, 芯片, amplifier, Doherty, power, matching, network, main, auxiliary, radio, frequency

### C. DOCUMENTS CONSIDERED TO BE RELEVANT

| Category* | Citation of document, with indication, where appropriate, of the relevant passages | Relevant to claim No. |
| --- | --- | --- |
| PX | CN 116582093 A (VANCHIP (TIANJIN) ELECTRONIC TECHNOLOGY CO., LTD.) 11 August 2023 (2023-08-11) claims 1-10, and description, paragraphs [0050]-[0120], and figures 1-15 | 1-10 |
| X | CN 115037253 A (CHENGDU FLUXWORKS TECHNOLOGY CO., LTD.) 09 September 2022 (2022-09-09) description, paragraphs [0035]-[0049], and figures 2-6 | 1, 4-8, 10 |
| Y | CN 115037253 A (CHENGDU FLUXWORKS TECHNOLOGY CO., LTD.) 09 September 2022 (2022-09-09) description, paragraphs [0035]-[0049], and figures 2-6 | 2, 3, 9 |
| Y | CN 106533374 A (RDA MICROELECTRONICS, INC.) 22 March 2017 (2017-03-22) description, paragraphs [0033]-[0060], and figures 1-9 | 2, 3, 9 |
| A | CN 114070210 A (VANCHIP (TIANJIN) ELECTRONIC TECHNOLOGY CO., LTD.) 18 February 2022 (2022-02-18) entire document | 1-10 |

☑ Further documents are listed in the continuation of Box C.   ☑ See patent family annex.

| | | |
| --- | --- | --- |
| * | Special categories of cited documents: | |
| "A" | document defining the general state of the art which is not considered to be of particular relevance | "T" later document published after the international filing date or priority date and not in conflict with the application but cited to understand the principle or theory underlying the invention |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
| --- | --- |
| **12 December 2023** | **22 December 2023** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2023/119549** |

**C.        DOCUMENTS CONSIDERED TO BE RELEVANT**

| Category* | Citation of document, with indication, where appropriate, of the relevant passages | Relevant to claim No. |
| --- | --- | --- |
| A | CN 113922780 A (NANJING UNIVERSITY OF POSTS AND TELECOMMUNICATIONS et al.) 11 January 2022 (2022-01-11)<br>    entire document | 1-10 |
| A | CN 114172469 A (HANGZHOU DIANZI UNIVERSITY) 11 March 2022 (2022-03-11)<br>    entire document | 1-10 |
| A | US 2009045877 A1 (INDUSTRIAL TECHNOLOGY RESEARCH INSTITUTE) 19 February 2009 (2009-02-19)<br>    entire document | 1-10 |

Form PCT/ISA/210 (second sheet) (July 2022)

## INTERNATIONAL SEARCH REPORT
### Information on patent family members

| International application No. |
| --- |
| **PCT/CN2023/119549** |

| Patent document cited in search report | | | Publication date (day/month/year) | Patent family member(s) | | | Publication date (day/month/year) |
| --- | --- | --- | --- | --- | --- | --- | --- |
| CN | 116582093 | A | 11 August 2023 | None | | | |
| CN | 115037253 | A | 09 September 2022 | None | | | |
| CN | 106533374 | A | 22 March 2017 | None | | | |
| CN | 114070210 | A | 18 February 2022 | CN | 114070210 | B | 20 September 2022 |
| | | | | WO | 2023138602 | A1 | 27 July 2023 |
| CN | 113922780 | A | 11 January 2022 | None | | | |
| CN | 114172469 | A | 11 March 2022 | None | | | |
| US | 2009045877 | A1 | 19 February 2009 | TW | 200910757 | A | 01 March 2009 |
| | | | | TWI | 346449 | B | 01 August 2011 |
| | | | | US | 7876159 | B2 | 25 January 2011 |

Form PCT/ISA/210 (patent family annex) (July 2022)